# EUROPEAN PATENT APPLICATION

(11) **EP 1 437 766 A2**
(43) Date of publication of application: **14.07.2004**
(21) Application number: 04250063.7
(22) Date of filing: 08.01.2004
(51) Int. Cl.: H01L 21/28, H01L 29/51

(54) **MOS transistor and its method of fabrication**

(30) Priority: 13.01.2003 US 341646
(71) Applicant: Hewlett-Packard Development Company, L.P., Houston, TX 77070 (US)
(72) Inventor: Chen, Zhizhang, Corvallis, OR 97330 (US); Liao, Hung, Corvallis, OR 97333 (US)
(74) Representative: Powell, Stephen David

(57) **Abstract**

A MOS transistor includes active regions (10, 14) defined in a substrate, an interfacial oxide thin film (16) upon the substrate, and a WSiNy gate dielectric thin film (18) which is formed upon the interfacial oxide thin film and isolates a gate (20) from the active regions.

## Description

The invention is in the semiconductor field and concerns MOS transistors. It particularly relates to MOS transistors with a high k gate dielectric.

One of the industrial hurdles in the development of MOS transistors scaled down to very small sizes, for example to ~0.1 µm, is the performance of gate dielectrics. The traditional gate dielectric in silicon MOSFET devices is SiO2. SiO2 is a stable gate dielectric material upon which the gate, typically polysilicon, may be formed. However, scaling of SiO2 gate dielectrics into the ultra-thin regime, i.e., less than ~20Å in thickness, has proven ineffective because devices begin to exhibit significant leakage current, i.e., parasitic electron flow, from the channel to the gate. Very thin SiO2 layers are recognized to be unstable and have reached practical limits. Thicker films can be maintained to avoid leakage current, but this interferes with device scaling into the sub-micron range. The industry has therefore looked to high dielectric constant (k) films as substitutes for SiO2.

The search for alternative gate dielectrics continues. One difficulty encountered in the use of alternative gate dielectrics is the need to use a separate barrier layer between a metal containing high-k dielectric and the gate, which is typically polysilicon. The function of the barrier is to prevent the reaction of precursors used to form the polysilicon with the high-k dielectric material. A precursor for polysilicon is silane (SiH4). Decomposition of the precursor produces hydrogen in the ambient that can react with exposed metal oxide bonds in a conventional metal oxide dielectric. These metal oxide dielectrics, e.g., ZrO2, provide exposed oxide bonds that react during the formation of polysilicon. This can degrade the dielectric layer and reduce its dielectric constant. Barrier layers can address this problem, but add a fabrication step. As a general principal, it is advantageous to reduce the number of fabrication steps.

Suitable gate dielectrics that may be deposited as ultra-thin layers, e.g., about ~10nm or less, should exhibit a high dielectric constant, low interface state density and good thermal stability. The physical and electrical properties of high dielectric constant gate dielectrics in MOS devices aren't as well known as the properties of SiO2. Many high-k materials, e.g., Ta2O5, HFO2, TiO2, SrTiO3, and BaSrTiO3, are thermally unstable when directly contacted with silicon and require a barrier layer. The barrier layers impose a thickness scaling limit.

A preferred MOS transistor of the invention includes active regions defined in a substrate. An interfacial oxide thin film is upon the substrate. A WSiNy gate dielectric thin film is formed upon the interfacial oxide thin film and isolates a gate from the active regions.
FIG. 1 is a schematic diagram of a MOS transistor according to a preferred embodiment of the invention;
FIG. 2 is a block diagram of a preferred embodiment method of the invention for forming a gate stack on the active region of a MOS; and
FIG. 3 is a plot explaining exemplary growth conditions for preferred embodiment dielectric WSiNy thin films.

A preferred MOS transistor of the invention includes ultra-thin dielectric films formed of WSiNy The dielectric film properties are controlled during formation to achieve a high dielectric constant k. In preferred embodiment transistors, WSiNy dielectric films are formed without a barrier layer and a gate is formed directly upon the dielectric film. Processes of the invention include deposition processes that set deposition conditions to control the dielectric properties of the dielectric thin films. A particular preferred process of the invention includes controlling deposition parameters, including N2 flow, plasma power, and deposition temperature to form WSiNy dielectric films during transistor formation. WSiNy films normally form not as a dielectric, but as films suited for barrier layers or conductive layers. The invention provides a method for predictably forming dielectric WSiNy films through control of N2 flow and monitoring of plasma power during deposition.

The invention will now be illustrated with respect to preferred embodiment MOS devices. In describing the invention, particular exemplary devices, formation processes, and device applications will be used for purposes of illustration. Dimensions and illustrated devices may be exaggerated for purposes of illustration and understanding of the invention. The elements of the drawings are not necessarily to scale relative to each other. Rather, emphasis has instead been placed upon clearly illustrating the invention. A single MOS device illustrated in conventional fashion by a two-dimensional schematic layer structure will be understood by artisans to provide teaching of three-dimensional device structures and integrations. Devices may be made and processes of the invention may be carried out with conventional integrated circuit fabrication equipment, as will also be appreciated by artisans.

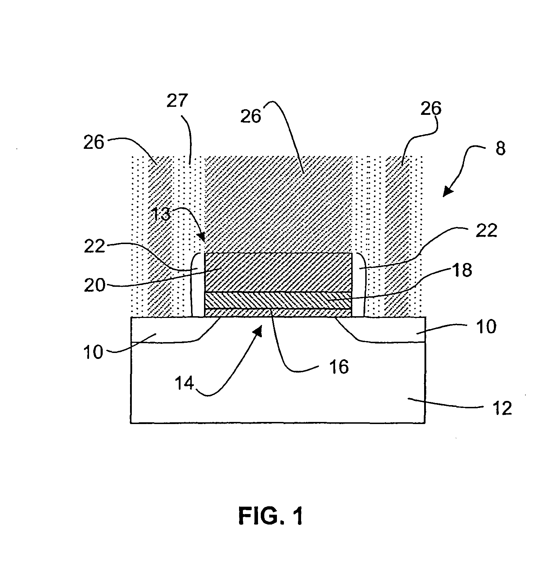

Referring now to FIG. 1, a preferred embodiment MOS transistor 8 of the invention is illustrated. The transistor has source and drain regions 10 defined in a substrate 12. These regions are formed conventionally, for example, by doping of a suitable semiconductor substrate. An exemplary substrate is a single crystal silicon wafer. Substrate, as used herein, includes a semiconductor layer having the active regions, i.e., source, drain and channel regions, and does not exclude the possibility of the substrate 12 being formed on another layer, such as a bulk layer that also might commonly be referred to as a substrate. The source and drain regions 10 defined in the substrate 12 are spaced apart from each other, as is conventional, defining an area of the substrate upon which a gate stack 13 may be formed. A channel region 14 is between the source and drain regions 10. An interfacial oxide thin film 16, e.g., a native oxide or SiO2, upon the substrate 12 facilitates the bond of a thin dielectric film 18. The thin interfacial oxide 16 layer preferably has a thickness of less than ~1 nm. In accordance with the invention, the gate dielectric thin film 18 is formed of dielectric WSiNy. The thin film 18 has a high dielectric constant k in the range of ~10 - ~35. The gate dielectric thin film 18 has a thickness of less than ~10nm, and preferably has a thickness in the range of ~2 - ~5 nm.

According to the preferred embodiment of FIG. 1, a gate 20, for example polysilicon, is formed directly upon the gate dielectric thin film 18 without use of a barrier layer. Formation of the gate 20 directly upon the gate dielectric WSiNy thin film 18 eliminates a formation process step, reducing the complexity and expense of a fabrication process to form the MOS transistor. The elimination of the barrier layer significantly simplifies transistor device and process integration. The WSiNy thin film 18 properties are stable during the deposition of the polysilicon gate 20, meaning any reaction with the precursors for gate deposition has a minimal or no effect on the gate dielectric thin film 18.

Oxide spacers 22 disposed upon the source and drain regions 10 and about the gate 20 reduce hot carrier effects. Contacts 26 are made to the gate 20 and the source and drain regions 10. Typically, the contacts will be formed through an interlevel dielectric 27. The contacts 26 in preferred applications of the invention form part of a circuit interconnect pattern included in an integrated circuit connecting the MOS transistor 8 to additional devices. The transistor 8 operates conventionally, with source and drain voltages controlling carrier flow in the channel region 14, and the gate voltage controlling the channel.

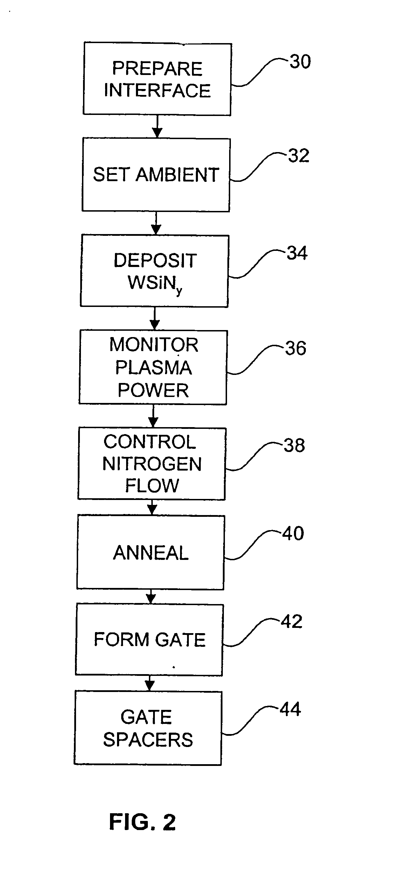

A preferred method for forming a gate stack on the active region of a MOS transistor will now be discussed with respect to FIG. 2. An initial step 30 is preparing the interface of the active region for deposition. This can include, for example, the formation of an interfacial layer. This may also include removal of excess native oxide from the interface, for example by a soft sputtering etch with Ar. In some embodiments, a thin ~1nm or less layer of native oxide is left as an interfacial layer. Embodiments of the invention may also include conventional steps prior to the preparing step 30 for forming the drain, source and channel regions of the transistor. Drain and source regions may also be formed later, for example after the gate stack, via implantation. After preparing the active region interface, ambient conditions for deposit of a thin film of dielectric WSiNy are set (step 32). An ambient of Ar + N2 may be used for WSiNy deposition. A WSi3N4 target may be sputtered in the ambient in the presence of an N2 flow to commence deposition of dielectric WSiNy (step 34).

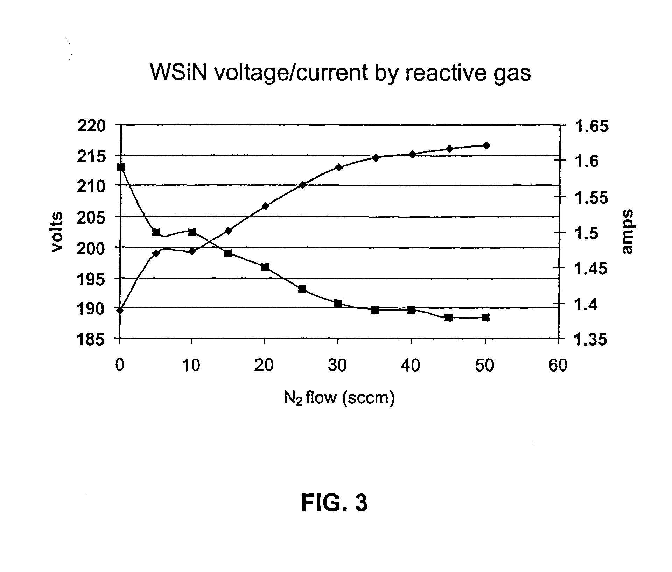

Reliable production of dielectric WSiNy is dependent upon the monitoring of the plasma power conditions during deposition (step 36) in a deposition chamber. Referring now to FIG. 3, the plasma voltage and power provide real-time information about the type of WSiNy that will deposit. The example graph illustrates the plasma voltage (left vertical scale graphed with diamond shaped points) and current (right vertical scale graphed with rectangle shaped points) relative to the nitrogen flow during deposition. At slightly less than about 20 sccm, plasma voltage increases rapidly while plasma current decreases rapidly. This point can vary depending on the other deposition conditions, i.e., reactor pressure, total power, relative gas flows, deposition temperature and type of target. In any case, the amount of nitrogen flow where plasma voltage begins to rapidly increase and plasma current begins to rapidly decrease is an accurate predictor that a dielectric WSiNy film will deposit at that and higher nitrogen flows. In conjunction with the control of nitrogen flow (step 38), the monitoring (step 36) ensures the formation of a high-k dielectric WSiNy film.

Advantageously, dielectric WSiNy films may be deposited at low temperatures, for example, room temperatures. The dielectric films may be annealed (step 40), for example in a rapid thermal anneal system, to relax bonds and prepare the interface and interface of the dielectric film for deposit of the gate directly thereupon. The annealing temperature may also be relatively low, e.g. ~450°C. Subsequently, the gate is formed (step 42) directly on the dielectric WSiNy film. Typically, this involves the formation of mask pattern with photolithography and a gate etch process, and the gate is deposited as part of a circuit interconnection pattern. After gate formation, gate oxide spacers are deposited (step 44) about the gate stack. After the spacers, doping may be conducted to form the source and drain regions of the transistor, for example, by implantation as known to those skilled in the art. In an integrated circuit formation process an interlevel dielectric and source and drain contacts may then be formed to complete a transistor and its integration with other like devices.

Transistors of the invention may be easily incorporated into integrated circuit processes without modification of conventional equipment used to form the integrated circuits. Without use of a barrier layer, a process step may be eliminated compared to processes which require a barrier layer to ensure that the gate dielectric does not degrade during deposition of the gate. This greatly simplifies transistor device and process integration

While a specific embodiment of the present invention has been shown and described, it should be understood that other modifications, substitutions and alternatives are apparent to one of ordinary skill in the art. Such modifications, substitutions and alternatives can be made without departing from the scope of the invention, which should be determined from the appended claims.

Various features of the invention are set forth in the appended claims.

## Claims

1. A MOS transistor, comprising:
a substrate (12);
active regions (10,14) in said substrate;
an interfacial oxide thin film (16) upon said substrate;
a WSiNy gate dielectric thin film (18) formed upon said interfacial oxide thin film; and
a gate (20) isolated from said active regions by said WSiNy gate dielectric
thin film.

2. The MOS transistor of claim 1, wherein said WSiNy gate dielectric thin film has a thickness of less than ~10nm.

3. The MOS transistor of claim 2, wherein said WSiNy gate dielectric thin film has a thickness in the range of ~2 ― ~5nm.

4. The MOS transistor of claim 1, further comprising spacers (22) disposed about said gate to reduce hot carrier effects.

5. The MOS transistor of claim 4, wherein said active regions comprise source, drain (10) and channel (14) regions, the transistor further comprising device contacts (26) to said gate and said source and drain regions.

6. The MOS transistor of claim 5, wherein said device contacts comprise part of a circuit interconnect pattern.

7. The MOS transistor of claim 6, formed as part of an integrated circuit.

8. A method for forming a MOS transistor gate dielectric WSiNy thin film, the method comprising steps of:
preparing an interface for deposit of the gate dielectric WSiNy thin film;
setting ambient conditions for deposit of the gate dielectric WSiNy thin film; and
depositing the gate dielectric WSiNy thin film.

9. The method according to claim 8, wherein said step of setting comprises controlling nitrogen flow to deposit dielectric WSiNy.

10. The method according to claim 9, wherein said step of depositing comprises monitoring plasma power during deposition and controlling the nitrogen flow to deposit dielectric WSiNy.
